# EUROPÄISCHE PATENTANMELDUNG

(11) **EP 1 128 186 A1**
(43) Veröffentlichungstag der Anmeldung: **29.08.2001**
(21) Anmeldenummer: 00890054.0
(22) Anmeldetag: 24.02.2000
(51) Int. Cl.: G01R 31/04

(54) **Prüfvorrichtung für Kabelbäume**

(71) Anmelder: I & T Innovation Technik Vertriebs-Ges.m.b.H., 7000 Eisenstadt (AT)
(72) Erfinder: Schindler, Uwe, 22941 Bargterheide (DE)
(74) Vertreter: Patentanwälte BARGER, PISO & PARTNER

(57) **Zusammenfassung**

Die Erfindung betrifft eine Prüfvorrichtung für Kabelbäume mit einem Prüftisch (4), in dem zumindest eine Aufnahme (3) für einen Stecker (1) der zu überprüfenden Kabelbäume (2) vorgesehen ist und mit zumindest einem druckluftbetätigten Haltemittel für den in die Aufnahme (3) eingesteckten Stecker (1) in zumindest einer ihrer Seitenwände

Die Erfindung ist dadurch gekennzeichnet, daß das Haltemittel ein elastischer oder elastisch gelagerter Bereich ist, der unter der Einwirkung der Druckluft gegen die benachbarte Gehäusewand des eingeschobenen Steckers (1) zur Anlage kommt.

In bevorzugten Ausgestaltungen ist das Haltemittel entweder ein in einer hinterschnittenen Nut liegender Schlauch oder eine in einem Ring gehaltene Membrane.

## Beschreibung

Die Erfindung betrifft eine Prüfvorrichtung für Kabelbäume, insbesondere betrifft die Erfindung Aufnahmen für die Stecker der zu überprüfenden Kabelbäume in einem Prüftisch.

Kabelbäume werden in der Automobil- und Kraftfahrzeugtechnik seit langem verwendet, um die einzelnen elektrischen Verbraucher mit Strom zu versorgen, um in diese Versorgungsleitungen die notwendigen Schalter einzubauen, um die Verbraucher bzw. die Schalter mit der Stromquelle zu verbinden und schließlich, in den letzten Jahren auch mehr und mehr, um Signale und Meßdaten zu übertragen.

So ist bei einem zeitgemäßen Automobil nicht nur die Batterie mit dem Anlasser und der Lichtmaschine zu verbinden, es sind auch die Scheinwerfer und Sicherheitsleuchten, der Scheibenwischer, die Windschutzscheiben- und die Scheinwerferwaschanlage, die Innenbeleuchtung und die Kofferraumbeleuchtung mit Strom zu versorgen, es werden Stromleitungen benötigt, um die Außenspiegel elektrisch zu verstellen und zu heizen, es werden Fensterheber und Sitzverstellmechanismen verwendet, die elektrisch funktionieren, es wird die Fahrbahntemperatur gemessen und zur Steuerung und Regelung der Temperatur des Fahrersitzes und oft auch des Lenkrades verwendet, es wird bei vielen Fahrzeugen der gehobenen Klasse die Entfernung zum voranfahrenden Fahrzeug festgestellt und in Abhängigkeit von der gemessenen Geschwindigkeit die Einhaltung eines Mindestabstandes zu diesem Fahrzeug überwacht und in vielen Fällen automatisch nicht unterschreitbar eingehalten, es bedarf das ABS und Antischlupfsystem einer Vielzahl von Steuer- und Versorgungsleitungen, es müssen die Computer, die das Funktionieren der Air-Bags überwachen und ihr Aktivieren auslösen, ebenso mit Strom versorgt werden, wie die Auslösevorrichtungen der Air-Bags selbst u.dgl. mehr.

Alle dazu notwendigen Kabel sind üblicherweise in einem einzigen, vielfach und fein verästelten Kabelbaum zusammengefaßt, der vom übrigen Fahrzeug getrennt hergestellt und getestet und anschließend während des Zusammenbaues des Fahrzeuges in diesem verlegt wird, eigentlich wird das Fahrzeug um den vorliegenden Kabelbaum herumgebaut.

Da nun nach erfolgter Verlegung eine Reparatur des Kabelbaumes praktisch ausgeschlossen ist, ist es notwendig, ihn möglichst unmittelbar nach seiner Herstellung und/oder unmittelbar vor seinem Einbau auf Richtigkeit der Kontaktierung und Abwesenheit von Fehlkontakten, Kurzschlüssen u.dgl. zu überprüfen.

Diese Überprüfung erfolgt nun so, daß auf einem Prüftisch jeder der vorhandenen Stecker des zu prüfenden Kabelbaumes, der später mit einem entsprechenden Stecker eines Verbrauchers, eines Schalters, eines Sensors, einer Stromquelle oder einer ähnlichen elektrischen Vorrichtung verbunden wird, in eine Aufnahme des Prüftisches gesteckt wird, die ihrerseits elektrisch mit einem passenden Simulationsbauteil verbunden ist, das die entsprechende Baueinheit des Fahrzeuges simuliert. Der Funktionstest wird von einem Computer überwacht, der die ordnungsgemäße Funktion des Kabelbaumes auf die beschriebene Weise überprüft und sein Prüfresultat auf einer Anzeige ausgibt und gegebenenfalls zu Kontrollzwecken speichert.

Da nun die Verbindungen der Stecker im Fahrzeugbau großen mechanischen Anfechtungen ausgesetzt sind (Erschütterungen, Vibrationen, Stöße, Hitze, Kälte, Eindringen von Feuchtigkeit, von Öl, von Schmutz etc.) und da anderseits mit wenigen Ausnahmen diese Verbindungen für die Lebensdauer des Fahrzeuges bestehen bleiben, verwendet man zur mechanischen Fixierung dieser Verbindungen zwischen dem kabelbaumseitigen Stecker und seinem fahrzeugseitigen Gegenstück Schnappmechanismen, die sich zerstörungsfrei kaum oder gar nicht lösen lassen.

Dies bedeutet, daß man in den Prüftischen zur Aufnahme der verschiedenen Stecker nicht einfach deren Gegenstücke verwenden kann, sondern, daß die Aufnahmen für die kabelbaumseitigen Stecker diese auf eine besondere Weise lösbar fixieren müssen. Gemäß dem Stand der Technik erreicht man diese lösbare Fixierung folgendermaßen:

Die Aufnahmen für die Stecker sind so ausgebildet, daß deren Haken, Leisten und Vorsprünge, die zur Verbindung mit ihrem jeweiligen Gegenstück dienen, Platz finden und sich mit keinem Teil der Aufnahme verhaken oder verbinden können. Die zwischen diesen federnden Zungen u.dgl. liegenden Wandbereiche der Stecker verlaufen im allgemeinen parallel zur Richtung der Kontaktstifte des Steckers, wenn sie auch nicht ununterbrochen durchlaufen, sondern meist verschiedene Querrillen oder Querleisten aufweisen, die zum Einhalten einer vorgegebenen Einstecktiefe in die entsprechenden Gegenstücke sichern und oft auch zur Verbesserung der Abdichtung zwischen dem Stecker und seinem Gegenstück dienen. Die Aufnahmen sind im Bereich dieser Steckerwände so ausgebildet, daß sie das Einführen des Steckers in die Aufnahme mit geringem Spiel (zügig) erlauben.

Um dieses Spiel auszugleichen und auch, um Toleranzen der Lage der Steckerkontakte auszugleichen, bestehen die aufnahmeseitigen Kontakte zumeist aus federnd gelagerten Stiften, die in die einzelnen Abteile der Stecker zu liegen kommen und die dortigen Kontakte berühren und Kontaktieren, ohne mit ihnen zu einem so innigen und intensiven Kontakt zu kommen, wie es zwischen den einzelnen Kontakelementen des Steckers und seines Gegenstückes im Fahrzeug selbst der Fall ist.

Weiters ist in der Aufnahme ein Fühler oder Schalter eingebaut, der aktiviert wird, wenn der zu prüfende Stecker eine vorbestimmte Einstecktiefe in der Aufnahme erreicht hat, die ausreicht, um eine sichere Kontaktierung zu garantieren und damit eine Überprüfung zu erlauben. Dieser Schalter kann beispielsweise ein verschieblicher Kontaktstift sein, der von einem Gehäuseteil des Steckers zwischen dessen Ausnehmungen für die eigentlichen Kontakte beim Einschieben des Steckers in die Aufnahme verschoben wird und nach einer vorbestimmten Verschiebelänge den ihm zugeordneten Kontakt schließt.

Durch das Schließen dieses Schalters wird ein magnetisch oder elektrisch gesteuertes Ventil in einer Druckluftleitung aktiviert, wodurch zumindest ein, in der Praxis üblicherweise zwei einander gegenüberliegende Druckluftzylinder entsprechende Kolbenstangen ausfahren und zwischen sich oder zwischen der Kolbenstange und einer Gegenfläche, den eingeschobenen Stecker in der jeweiligen Lage festhalten. Wenn nun vom Prüfpersonal alle Stecker eines Kabelbaumes eingesteckt sind, erkennt dies die Prüfautomatik oder sie wird entsprechend manuell aktiviert und überprüft den Kabelbaum, was in der Regel nur Sekunden oder Sekundenbruchteile dauert. Werden keine Fehler festgestellt, so erfolgt ein zentraler Befehl an die Druckluftsteuerung, die Druckluftzylinder zu entlüften oder, was zumeist der Fall ist, im Falle doppeltwirkender Druckluftzylinder entgegengesetzt zur Halteposition zu beaufschlagen, wodurch die einzelnen Stecker wieder frei kommen und durch die Kraft der federnden Kontakte aus den Ausnahmen ausgeschoben werden.

Diese Prüfvorrichtungen funktionieren im allgemeinen problemlos, sind aber kostenintensiv herzustellen. Anschaffungskosten im Bereich von etwa 150.000,00 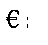 sind keine Seltenheit und auch dann ist ein solcher Prüftisch nicht in der Lage, alle Ausstattungsvarianten eines Kraftfahrzeugtyps zu testen, geschweige denn von unterschiedlichen Kraftfahrzeugtypen ein- und desselben Unternehmens.

Mit ein Grund für die Unzulänglichkeiten ist die Tatsache, daß die beiden Druckluftzylinder einen im Vergleich zur Steckergröße erheblichen Platzbedarf haben, durch den verhindert wird, daß mehrere Stecker eng nebeneinander angeordnet werden können. Eine solche eng aneinanderliegende Anordnung wäre aber in all den Fällen wünschenswert, in denen bei verschiedenen Ausstattungsvarianten eines Fahrzeugtypes an eng benachbarten Stellen des Kabelbaumes eine Vielzahl unterschiedlicher Stecker vorgesehen sind, denen derzeit aus Platzgründen am Prüftisch keine entsprechende Anzahl von Aufnahmen gegenübergestellt werden kann.

Die Erfindung bezweckt hier Abhilfe zu schaffen, und eine Fixierung der Stecker in den Aufnahmen eines Kabelbaum-Prüf-Tisches anzugeben, die wesentlich weniger Platz benötigt als die vorbekannten Fixierungen und dabei noch kostengünstiger zu schaffen ist.

Erfindungsgemäß ist dazu vorgesehen, in zumindest einem Bereich einer Seitenwand der Aufnahme einen elastischen oder elastisch gelagerten Bereich vorzusehen, der unter der Einwirkung von Druckluft gegen die benachbarte Gehäusewand des eingeschobenen Stekkers zur Anlage kommt.

Auf diese Weise wird es möglich, statt des mechanisch und damit kostenmäßig aufwendigen Zylinderpaares, eine oder zwei Membranen oder Schläuche zu verwenden, die in Ausnehmungen der Seitenwand bzw. Seitenwände angeordnet sind und unter der Einwirkung von Druckluft flächig am Steckergehäuse anliegen und so für einen Reibschluß und damit für die Fixierung des Steckers in der Aufnahme sorgen. Zufolge der elastischen Ausbildung bzw. der elastischen Lagerung ist es nicht notwendig, einen doppelt wirkenden Mechanismus vorzusehen, beim Lüften des Anpreßvolumens genügen die elastischen Rückstellkräfte der Halteorgane in Verbindung mit den federnden Kontaktstiften, um den Stecker, wie auch bisher, zumindest ein Stück aus der Aufnahme zu schieben und ihn so frei zu geben.

In einer bevorzugten Ausführungsform besteht die erfindungsgemäße Vorrichtung aus zumindest einer hinterschnittenen Nut in einer oder mehreren der Seitenwände der Aufnahme, in die ein elastisches, schlauchartiges Gebilde eingelegt ist. Beim Aufbringen der Druckluft, nach heutiger Technik zumeist 6 bar, liegt der Schlauch satt in der hinterschnittenen Nut und wölbt sich über deren Oberfläche, wobei er die ihm gegenüberstehende Gehäusewand des eingeschobenen Steckers kontaktiert und festhält. Da es dabei zu einer, im Vergleich zu den gemäß dem Stand der Technik anliegenden Kolbenstangenenden, großflächigen Berührung kommt, ist die Haltekraft, trotz der der Druckluft entgegenwirkenden elastischen Rückstellkraft des Schlauches bei weitem ausreichend, um zu einer sicheren Fixierung zu kommen. Diese Haltekraft kann durch eine die Reibung erhöhende Beschichtung oder Ausbildung der Oberfläche des schlauchähnlichen Gebildes noch deutlich erhöht werden.

Das schlauchähnliche Gebilde muß nicht kreisrund oder oval sein, es muß auch nicht über seinen Umfang gleiche Struktur und Stärke aufweisen, sondern kann balgartige Bereiche besitzen, an denen die Deformation konzentriert wird.

In einer anderen Ausgestaltung wird eine bevorzugt kreisförmige Membrane, die von einem Ring gehalten wird, über einer Vertiefung in der Seitenwand der Aufnahme befestigt, bevorzugt eingeschraubt oder mittels eines Bajonettverschlusses od.dgl. montiert, wobei dieser Schraub- oder Bajonettverschluß auf dem Ring angeordnet ist, sodaß der Austausch rasch und problemlos erfolgen kann. Der Hohlraum, der von der Membrane abgedeckt wird, steht über eine passende Bohrung mit der Druckluftversorgung in Verbindung und die Membrane schafft eine im wesentlichen kreisförmige Kontaktfläche mit der Gehäusewand des eingeschobenen Steckers, wenn der Hohlraum mit Druckluft beaufschlagt wird.

Es sind selbstverständlich noch viele andere Varianten denkbar, so kann die hinterschnittene Nut und damit der zugehörige schlauchartige Körper in Spiralform oder in U-Form in einer Seitenwand der Aufnahme angeordnet sein oder auch einstückig über mehrere der Seitenwände der Aufnahme geführt werden. Auch dabei ist ein Auswechseln eines undicht gewordenen schlauchartigen Gebildes unproblematisch, es kann entweder entlang der Nut ausgezogen bzw. wieder eingeschoben werden oder es kann durch elastische Verformung durch die Öffnung der Nut in diese eingesteckt werden.

Die Erfindung wird im folgenden an Hand eines Beispieles näher erläutert. Dabei zeigt
die Fig. 1 rein schematisch einen Stecker und eine zugehörige Aufnahme,
die Fig. 2 einen Schnitt durch eine erste Ausführungsform, bei der ein schlauchartiges Gebilde in einer hinterschnittenen Nut angeordnet ist,
die Fig. 2a ein Detail der Fig. 2,
die Fig. 3 eine Ausführungsform mit einer von einem Ring gehaltenen Membrane und die Fig. 4 eine Variante der Fig. 2.

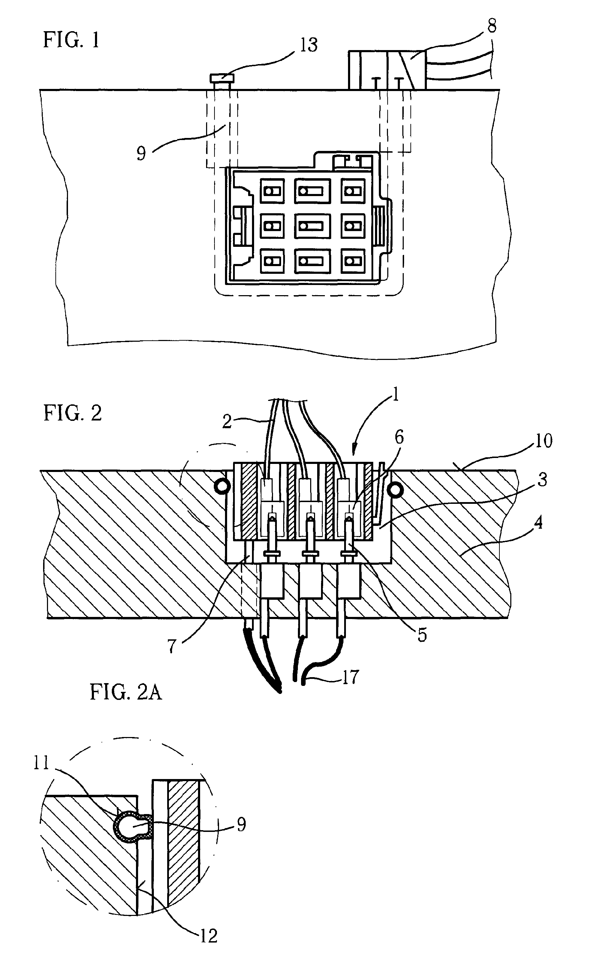

Die Fig. 1 und Fig. 2 zeigen rein schematisch einen Stecker 1 mit Kontakten 6 eines zu prüfenden Kabelbaumes 2, der in eine Aufnahme 3 eines Kabelprüftisches 4 eingeschoben ist.

In dem in Fig. 2 dargestellten Zustand besteht elektrischer Kontakt zwischen federnd gelagerten Stiften 5 der Aufnahme 3 und den elektrischen Kontakten 6 im Stecker 1. Ein rein schematisch angedeuteter Schalter 7 hat festgestellt, daß der Stecker 1 ausreichend weit in die Aufnahme 3 eingesteckt worden ist und aktiviert ein Magnetventil 8, das zufolge dieser Aktivierung Druckluft von einer nicht dargestellten Druckluftversorgung in einen erfindungsgemäß verwendeten Schlauch 9 leitet. Der Schlauch 9 führt im dargestellten Ausführungsbeispiel im wesentlichen parallel zur Oberfläche 10 des Prüftisches 4 von einer der Tischseitenkanten wieder zu dieser zurück, wobei der Schlauch teilweise in einer lochförmigen Ausnehmung, teilweise in einer kreisbogenförmigen Nut 11 gelagert ist.

Der Querschnitt dieser Nut geht aus der Detailansicht in Fig. 2a hervor, es handelt sich dort um eine Nut mit abschnittweise kreisbogenförmigem Querschnitt, die zu einer Seitenwand 12 der Aufnahme 3 über einen Sehnenbereich offen ist, der kleiner ist als der Durchmesser des Kreisbogenabschnittes. Damit ist sichergestellt, daß der Schlauch 9 auch im drucklosen Zustand nicht aus der Nut 11 herausfällt.

Das dem Magnetventil 8 abgewandte Ende 13 des Schlauches 9 ist auf passende Weise luftdicht verschlossen oder es weist ein Entlüftungsventil auf. Ist letzteres der Fall, so ist das Magnetventil 8 nur zwischen den Positionen "Verbinden mit der Druckluftquelle" oder "Absperren von der Druckluftquelle" verstellbar, während das zusätzliche am Ende 13 angeordnete Magnetventil den Schlauch 9 mit der Umgebung verbindet oder ihn schließt.

Im dargestellten Ausführungsbeispiel ist der Schlauch 9 am Ende 13 aber dauerhaft dicht verschlossen, beispielsweise mittels eines Nippels oder Stoppels und das Magnetventil 8 verbindet den Schlauch 9 entweder mit der Druckluftquelle oder es verbindet ihn mit der Umgebung.

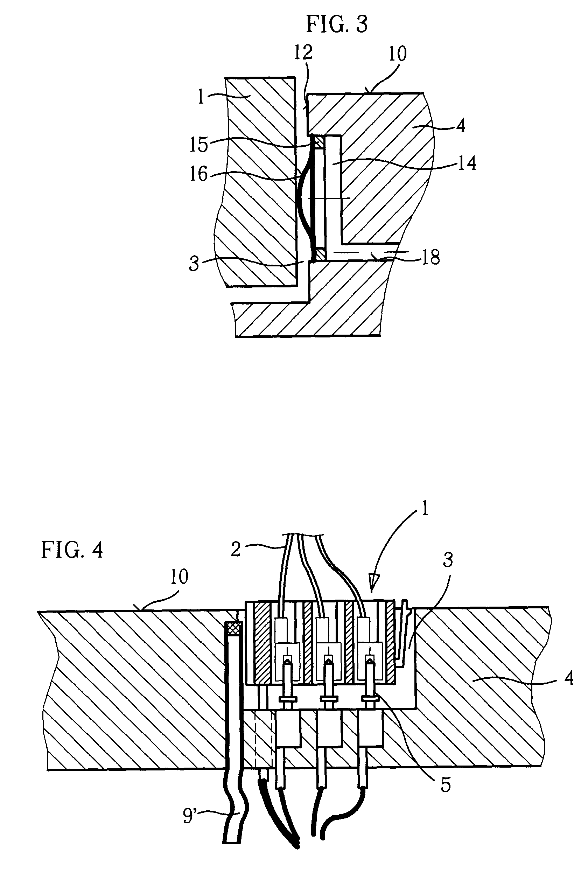

Eine Variante dieser Ausführungsform ist in Fig. 4 dargestellt. Dabei ist der Schlauch 9' im wesentlichen parallel zur Einsteckrichtung des Steckers 1 in die Aufnahme 3 angeordnet und an seinem Ende noch unterhalb der Oberfläche 10 des Prüftisches 4 verschlossen. Es kann selbstverständlich der Schlauch 9 auch in Zick-Zack-Form in U-Form entlang einer oder mehrerer der Wände der Aufnahme 3 oder auf andere Weise geführt werden, wesentlich ist nur, daß die ihn aufnehmende Nut 11 entsprechende Form und Abmessung hat, um einerseits ein Festhalten auch des schlaffen Schlauches zu gewährleisten und anderseits ein genügend weites Austreten des Schlauches im aufgeblasenen Zustand über die Seitenwand 12 zu erlauben.

Es ist selbstverständlich nicht notwendig, daß für eine Aufnahme nur ein Schlauch vorgesehen ist, diese Frage ist, ebenso wie die Anordnung des zugehörigen Magnetventils, in Fig. 4 offen geblieben. Es ist nämlich durchaus möglich, mit einem Magnetventil 8 mehrere zu einer Aufnahme gehörenden Schläuche 9 zu versorgen.

Eine Variante der Erfindung ist in Fig. 3 dargestellt. Dabei weist eine der Wände 12 der Aufnahme 3 des Prüftisches 4 eine kreisförmige Vertiefung 14 auf, die nach außen, zum zu prüfenden Stecker 1 hin, mit einer in einem Ring 15 gehaltenen Membran 16 verschlossen ist.

Die Membran 16 kann mit dem Ring verklebt oder verschweißt, beispielsweise reibverschweißt oder Ultraschall-verschweißt sein, es kann unter Umständen auch die Membrane 16 bei passender Ausgestaltung einstückig mit dem Ring 15 ausgebildet sein, wenn es sich beispielsweise um eine Kunststoffeinheit handelt, die durch Spritzgießen oder Spritzgießen und anschließendes Tiefziehen hergestellt worden ist.

Die Befestigung des Ringes 15 in der Vertiefung 14 kann durch Einschrauben oder auch nur durch Einstecken erfolgen, eventuell geringe Undichtigkeiten spielen im Vergleich zu der Menge der zur Verfügung stehenden Druckluft keine Rolle. Bevorzugt wird aber ein Einschrauben oder eine Verriegelung mittels eines Bajonettverschlusses od.dgl.

Das zugehörige Magnetventil sitzt an passender Stelle unterhalb oder am Rande des Prüftisches 4, im dargestellten Fall mit nur einer Zuführbohrung 18 für die Druckluft handelt es sich um ein Ventil, das auch die Belüftung der Druckkammer 14 besorgt. Selbstverständlich wäre es möglich, eine zweite Bohrung vorzusehen, an deren Ende ein Entlüftungsventil sitzt, doch ist dies aus Kostengründen nur in seltenen Fällen vorteilhaft.

Die Erfindung ist nicht auf das dargestellte Ausführungsbeispiel beschränkt, sondern kann verschiedentlich abgewandelt werden. So ist es möglich, die verschiedenen gezeigten Varianten zu kombinieren oder auch abzuwandeln. Die verwendeten Schläuche müssen nicht rund, wie die dargestellten Schläuche 9 sein, sondern können, wie weiter oben erwähnt, anderen Querschnitt aufweisen und insbesondere faltenbalgähnliche Gebilde entlang einer Erzeugenden besitzen, um in einer bevorzugten Richtung besonders dehnbar zu sein. Es brauchen dann selbstverständlich die zugehörigen Nuten nicht Kreisbogenquerschnitt aufweisen, sondern sie können jeweils angepaßt an die Schlauchform ausgebildet sein.

Gleiches gilt bei Verwendung von flexiblen Membranen 14, die zugehörigen Befestigungsringe müssen nicht kreisförmig sein, sondern können oval und im Extremfall auch rechtekkig oder quadratisch sein. Die Montage kann auf andere Art und Weise als dargestellt erfolgen und auch die Anordnung der Magnetventile zur Füllung bzw. Lüftung der Druckluftabschnitte ist in großem Ausmaß frei wählbar. So ist es möglich, diese Ventile an einer Stelle des Prüftisches 4 zu konzentrieren oder überhaupt getrennt von ihm anuordnen, solange nur die Leitungen zu den Schläuchen 9 bzw. Membranen 16 eine Geschwindigkeit der Deformation gewährleisten, die zum zuverlässigen Festhalten der eingesteckten Stekker 1 ausreicht. Es ist in einem solchen Fall möglich, die entsprechenden Zuleitungen zu den Schläuchen 9 bzw. den Membranen 16 mit den Kabelbündeln 17 zu vereinen, die zu den einzelnen Aufnahmen 3 führen. In diesem Falle wäre für jede Aufnahme 3 eines Prüftisches 4 nur ein flexibler Verbund von Drähten und Schläuchen hinzuführen, der über entsprechende Kupplungselemente verfügt, die mit den Gegenstücken der jeweiligen Aufnahme verbunden werden. Auf diese Weise ist ein großer Schritt in Richtung zu einem modularen System getan, durch den der Aufbau, die Reparatur und auch Adjustierung eines Prüftisches 4 deutlich verbilligt werden kann.

## Patentansprüche

1. Prüfvorrichtung für Kabelbäume mit einem Prüftisch (4), in dem zumindest eine Aufnahme (3) für einen Stecker (1) der zu überprüfenden Kabelbäume (2) vorgesehen ist, mit zumindest einem mittels Druckluft betätigten Haltemittel für den in die Aufnahme (3) eingesteckten Stecker (1) in zumindest einer ihrer Seitenwände, dadurch gekennzeichnet, daß das Haltemittel ein elastischer oder elastisch gelagerter Teil ist, der unter der Einwirkung der Druckluft gegen die benachbarte Gehäusewand des eingeschobenen Steckers (1) zur Anlage kommt.

2. Prüfvorrichtung nach Anspruch 1, dadurch gekennzeichnet, daß das Haltemittel ein Schlauch (9,9') mit zumindest einem dehnbaren Bereich ist, der in einer hinterschnittenen Nut (11) zumindest einer Seitenwand (12) der Aufnahme (3) angeordnet ist.

3. Prüfvorrichtung nach Anspruch 2, dadurch gekennzeichnet, daß ein längerer Abschnitt der Nut (11) im wesentlichen parallel zur Oberfläche (10) des Prüftisches (4) verläuft.

4. Prüfvorrichtung nach Anspruch 2, dadurch gekennzeichnet, daß ein längerer Abschnitt der Nut (11) im wesentlichen normal zur Oberfläche (10) des Prüftisches (4) verläuft.

5. Prüfvorrichtung nach einem der Ansprüche 2 bis 4, dadurch gekennzeichnet, daß der Schlauch (9,9') als Ganzes elastisch ausgebildet ist und kreisförmigen Querschnitt aufweist, und daß die Nut (11) einen kreisbogenförmigen Querschnitt mit mehr als der halben Kreisquerschnittsfläche aufweist.

6. Prüfvorrichtung nach Anspruch 1, dadurch gekennzeichnet, daß das Haltemittel eine Membrane (16) ist, die von einem Ring (15) gehalten wird und eine Vertiefung (14) in einer der Seitenwände (12) abdeckt.

7. Prüfvorrichtung nach Anspruch 6, dadurch gekennzeichnet, daß der Ring (15) mit einem Außengewinde versehen ist, mit dem er in ein Innengewinde der Vertiefung (14) geschraubt wird.

8. Prüfvorrichtung nach Anspruch 6, dadurch gekennzeichnet, daß der Ring (15) mit einem Bajonettverschlußteil versehen ist, der mit einem korrespondierenden Bajonettverschlußteil der Vertiefung (14) verbunden wird.
